# FASCICULE DE BREVET EUROPEEN

(11) **EP 0 898 187 B1**
(45) Date de publication et mention de la délivrance du brevet: **20.12.2006**
(21) Numéro de dépôt: 98401560.2
(22) Date de dépôt: 25.06.1998
(51) Int. Cl.: G02B 6/42

(54) **Dispositif semi-conducteur à moyen électronique d'échanges à distance de signaux**
Halbleitervorrichtung mit elektronischen Mitteln zum Übertragung von Signalen
Semiconductor device with electronic signal transmission means

(30) Priorité: 18.08.1997 FR 9710429
(43) Date de publication de la demande: 24.02.1999
(73) Titulaire: STMicroelectronics S.A., 92120 Montrouge (FR); FRANCE TELECOM, 75015 Paris (FR)
(72) Inventeur: Jaouen, Hervé, 38240 Meylan (FR); Marty, Michel, 38760 Varces (FR)
(74) Mandataire: Casalonga, Axel

(56) Documents cités:
- EP-A- 0 305 112
- EP-A- 0 726 477
- US-A- 5 345 529
- HAYASHI T ET AL: "OPTICAL MODULE WITH MU CONNECTOR INTERFACE USING SELF-ALIGNMENT TECHNIQUE BY SOLDER-BUMPE CHIP BONDING" 1996 PROCEEDINGS OF THE 46TH. ELECTRONIC COMPONENTS AND TECHNOLOGY CONFERENCE, ORLANDO,28 mai 1996, pages 13-19, XP000646648 IEEE
- DESHMUKH R D ET AL: "ACTIVE ATMOSPHERE SOLDER SELF-ALIGNMENT AND BONDING OF OPTICAL COMPONENTS" INTERNATIONAL JOURNAL OF MICROCIRCUITS AND ELECTRONIC PACKAGING, vol. 16, no. 2, 1 janvier 1993, pages 97-107, XP000349286
- PATENT ABSTRACTS OF JAPAN vol. 1997, no. 01 31 Janvier 1997 & JP 08 248 274 A (NIPPON TELEGR & TELEPH CORP) 27 Septembre 1996

## Description

La présente invention concerne le domaine de la microélectronique et plus particulièrement un dispositif semi-conducteur comprenant une pastille formant un circuit intégré et un substrat de connexion dans lequel sont prévus, entre les faces juxtaposées de la pastille et du substrat, des éléments ponctuels ou billes de connexion du substrat à la pastille répartis sous la forme d'une matrice et dans lequel le substrat présente des moyens de connexion extérieure reliés auxdites billes de connexion.

La présente invention concerne plus particulièrement un dispositif semi-conducteur qui comprend en outre au moins un moyen d'échanges de signaux lumineux disposé dans une zone exempte d'éléments ponctuels de connexion et comprenant deux parties optoélectroniques comprenant respectivement au moins un émetteur et au moins un récepteur disposés à distance et en regard l'un de l'autre et susceptibles d'échanger entre eux des signaux lumineux, l'une desdites parties étant intégrée dans ladite pastille et constituant un composant dudit circuit intégré et l'autre partie comprenant au moins une fibre optique dont une partie d'extrémité est engagée au travers d'un orifice traversant dudit substrat, de manière à coupler optiquement et à distance l'extrémité de ladite fibre à la partie dudit moyen d'échanges intégrée dans ladite pastille, au travers de l'espace séparant la pastille et le substrat.

De tels dispositifs semi-conducteurs, connus, présentent les dispositions suivantes.

Dans le document XP000646648 IEEE (pages 13-19), la fibre optique traverse une douille de centrage portée par le substrat. Dans le document EP-A-726 477, l'extrémité de la fibre optique et la plaque portant la pastille sont équipées de moyens complémentaires élastiques de positionnement. Dans le document EP-A-305 112, le bord périphérique de l'extrémité de la fibre optique est en appui contre la paroi d'un orifice tronconique et une résine de fixation de cette extrémité remplit par l'extérieur la partie ouverte de cet orifice. Dans le document US-A-5 345 529, l'extrémité de la fibre optique est engagée dans le petit diamètre d'un orifice tronconique et une résine de fixation de cette extrémité remplit par l'extérieur cet orifice.

La présente invention a pour objet un dispositif semi-conducteur dont la structure est simplifiée et améliorée.

Selon la présente invention, le dispositif semi-conducteur comprend une résine d'étanchéité, de collage et de renforcement mécanique, transparente auxdits signaux lumineux, injectée dans l'espace séparant ladite pastille et ledit substrat et fixant ladite fibre optique dans ledit orifice.

Selon l'invention, la paroi de l'orifice traversant ledit substrat et recevant l'extrémité de ladite fibre présente des rainures axiales, ladite résine pénétrant dans ces rainures.

Selon l'invention, ledit orifice s'étend perpendiculairement à l'espace séparant la pastille et le substrat.

Selon l'invention, lesdits moyens de connexion du substrat comprennent de préférence des plots ou billes de connexion extérieure répartis sous la forme d'une matrice sur sa surface opposée à la pastille.

Selon l'invention, le substrat constitue de préférence une portion de la paroi d'un boîtier d'encapsulation de ladite pastille.

La présente invention sera mieux comprise à l'étude de dispositifs semi-conducteurs décrits à titre d'exemples non limitatifs et illustrés par le dessin sur lequel:
- la figure 1 représente une coupe schématique transversale d'un dispositif semi-conducteur selon l'invention ;
- la figure 2 représente une coupe agrandie de la figure 1, montrant une première variante d'un dispositif semi-conducteur selon la présente invention ;
- la figure 3 représente une coupe agrandie de la figure 1, montrant une seconde variante du dispositif semi-conducteur selon la présente invention ;
- et la figure 4 représente une vue extérieure partielle du dispositif semi-conducteur des figures 2 et 3.

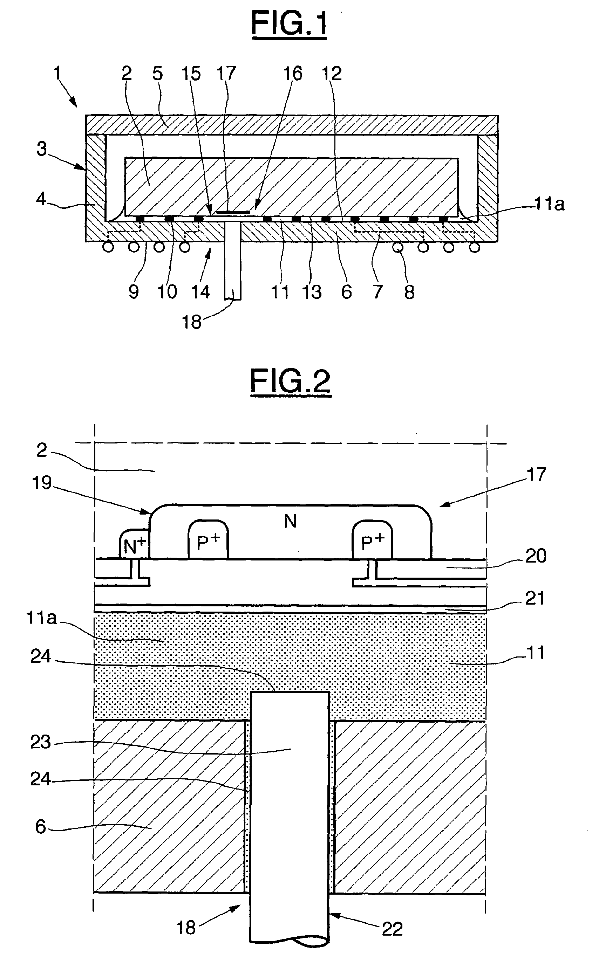

En se reportant à la figure 1, on voit qu'on a représenté un dispositif semi-conducteur repéré d'une manière générale par la référence 1 qui comprend une pastille 2 formant un circuit intégré, encapsulée dans un boîtier 3 qui comprend une cuvette 4 et un couvercle 5.

Le fond 6 de la cuvette 4 est constitué par un substrat intégrant une multiplicité de lignes de connexion 7 reliant des billes de connexion extérieure 8 disposées sur la face extérieure 9 de la paroi 6 à des billes de connexion 10 interposées dans l'espace 11 séparant la face intérieure 12 de la paroi 6 du boîtier 3 et la face avant 13 de la pastille 2, ces billes 10 étant reliées au circuit intégré dans la pastille 2.

Les billes de connexion extérieure 8 et les billes de connexion intérieure 10 sont réparties sous la forme de matrice laissant des zones correspondantes 14 et 15 situées de part et d'autre de la paroi 6 du boîtier 3 exemptes de billes et exemptes de connexions internes dans cette paroi 6.

Dans les zones 14 et 15 exemptes de billes, le dispositif semi-conducteur 1 comprend un moyen optoélectronique 16 d'échanges de signaux lumineux en deux parties, dont une partie 17 constitue un composant du circuit intégré dans la pastille 2 et dont une partie 18 est portée par la paroi 6 du boîtier 3, ces parties 17 et 18 étant susceptibles d'échanger des signaux lumineux au travers de l'espace 11 séparant la pastille 2 et la paroi 6 du boîtier 3.

En se reportant à la variante de la figure 2, on voit que la partie 17 comprend un récepteur optoélectronique 19 constitué par exemple par une diode sensible à la lumière, constituant un composant du circuit intégré dans la pastille 2. Cette diode constitue un dernier composant dans le sens de l'épaisseur de la pastille et est réalisée en arrière d'une couche d'isolant 20 de dioxyde de silicium et d'une couche superficielle 21 de passivation.

La partie 18 portée par la paroi 6 du boîtier 3 comprend un fibre optique 22 dont une partie d'extrémité 23 est engagée dans un orifice traversant 24 de la paroi 6, réalisé dans le sens de son épaisseur, perpendiculairement à l'espace 11, de telle sorte que son extrémité 25 soit orientée en direction de la diode réceptrice 19 intégrée dans la pastille 2.

La fibre optique 22 présente, à l'extérieur du dispositif semi-conducteur 1, une branche libre dont l'extrémité peut être adaptée pour être connectée à un émetteur de signaux lumineux, la fibre optique 22 véhiculant ces signaux jusqu'à son extrémité 24 qui constitue un émetteur couplé à la diode réceptrice 13 au travers de l'espace 11 séparant la pastille 2 de la paroi 6 du boîtier 3. Les signaux ainsi captés par la diode réceptrice 19 sont transformés par cette dernière en signaux électriques qui peuvent être traités par d'autres composants intégrés dans la pastille 2.

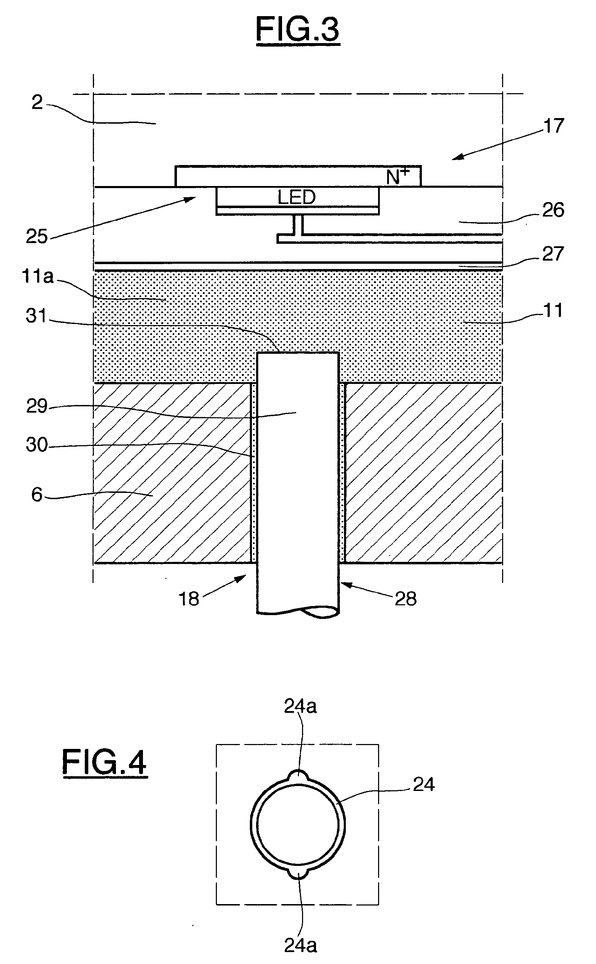

Comme on peut le voir sur la figure 4, la paroi de l'orifice 24 traversant la paroi 6 du boîtier 3 et recevant l'extrémité 23 de la fibre 22, présente des rainures axiales 24a. Dans l'espace 11 séparant la pastille 2 de la paroi 6 du boîtier 3, est injectée une résine d'étanchéité 1 la qui permet de renforcer la liaison mécanique entre la pastille 2 et le boîtier 3 et qui en outre pénètre dans l'orifice 24 et ses rainures axiales 24a de manière à fixer l'extrémité 23 de la fibre 22 à la paroi 6 du boîtier 3. La résine d'étanchéité 1la est bien entendu choisie de manière à être transparente aux signaux lumineux s'échangeant entre la fibre optique 22 et la diode réceptrice 19.

La fabrication du dispositif semi-conducteur 1 peut être réalisée de la manière suivante.

Tout d'abord, on réalise le perçage 24 de la paroi 6 du boîtier 3, par exemple par gravure ultra-sons. On soude la pastille 2 sur la paroi 6, par l'intermédiaire des billes de connexion 10. On met en place l'extrémité 23 de la fibre optique 22 dans l'orifice traversant 24. On injecte la résine d'étanchéité et de collage 11a dans l'espace 11 séparant la pastille 2 et la paroi 6 du boîtier 3 et, après polymérisation et durcissement de cette résine, on réalise l'encapsulation en fixant le couvercle 5 du boîtier 3 sur sa cuvette 4.

En se reportant à la variante représentée sur la figure 3, on voit que la partie 17 du moyen d'échanges 16 comprend un émetteur de signaux lumineux, en particulier constitué par une diode électroluminescente 25 obtenue notamment par hétéroépitaxy de matériaux de la classe III-V, notamment de GaAS, constituant un dernier composant intégré dans la pastille 2 dans le sens de son épaisseur, en arrière d'une couche isolante de dioxyde de silicium 26 et d'une couche terminale de passivation 27.

Comme dans la variante de réalisation de la figure 2, la partie 18 du moyen d'échange 16 comprend une fibre optique 28 dont la partie d'extrémité 29 est engagée et fixée dans un orifice traversant 30 de la paroi 6 du boîtier 3. L'extrémité 31 de la fibre optique 28, située dans l'espace 11 séparant est susceptible de capter les signaux lumineux émis par la diode émettrice 25 intégrée dans la pastille 2 au travers de l'espace 11 séparant la pastille 2 et la paroi 6 du boîtier 3.

Les signaux lumineux captés par l'extrémité fixe 31 de la fibre optique 28 sont transportés par cette dernière jusqu'à son autre extrémité, extérieure au boîtier 3, qui peut être reliée à un récepteur de signaux lumineux.

Il convient d'observer que les moyens d'échanges de signaux lumineux 16, qui viennent d'être décrits en référence aux figures 2 et 3, ne présentent aucune liaison galvanique et n'engendrent aucun effet parasite résultant des connexions habituelles par conduction électrique d'entrée/sortie, permettant ainsi de supprimer au moins certains des circuits de protection habituellement intégrés dans la pastille 2. Il permet en outre des entrées et/ou sorties de données à des débits très élevés.

Bien entendu, la pastille 2 pourrait comprendre plusieurs diodes émettrices et/ou réceptrices, la paroi 6 du boîtier 2 portant, en vis-à-vis, autant de fibres couplées optiquement auxdites diodes.

## Revendications

1. Dispositif semi-conducteur (1) comprenant une pastille (2) formant un circuit intégré et un substrat de connexion (6), dans lequel sont prévus, entre des faces juxtaposées de la pastille (2) et du substrat (6), des éléments ponctuels ou billes de connexion (10) répartis sous la forme d'une matrice et dans lequel le substrat (6) présente des moyens de connexion extérieure (8) reliés auxdits éléments ponctuels de connexion (10), comprenant en outre au moins un moyen d'échanges de signaux lumineux disposé dans une zone exempte d'éléments ponctuels de connexion et comprenant deux parties optoélectroniques comprenant respectivement au moins un émetteur et au moins un récepteur disposés à distance et en regard l'un de l'autre et susceptibles d'échanger entre eux des signaux lumineux, l'une (17) desdites parties étant intégrée dans ladite pastille (2) et constituant un composant dudit circuit intégré et l'autre partie (18) comprenant au moins une fibre optique (22) dont une partie d'extrémité (23) est engagée au travers d'un orifice (24) traversant dudit substrat (6), de manière à coupler optiquement et à distance l'extrémité de ladite fibre (22) à la partie dudit moyen d'échanges intégrée dans ladite pastille, au travers de l'espace (11) séparant la pastille (2) et le substrat (6), **caractérisé par le fait que** la paroi (6) de l'orifice (24) traversant ledit substrat (6) et recevant l'extrémité (23) de ladite fibre (22) présente des rainures axiales (24a) et qu'il comprend une résine d'étanchéité, de collage et de renforcement mécanique (11a), transparente auxdits signaux lumineux, injectée dans l'espace (11) séparant ladite pastille (2) et ledit substrat (6) et fixant ladite fibre optique dans ledit orifice (24) en pénétrant dans lesdites rainures axiales (24a).

2. Dispositif semi-conducteur selon la revendication 1, **caractérisé par le fait que** ledit orifice (24) s'étend perpendiculairement à l'espace (11) séparant la pastille et le substrat.

3. Dispositif semi-conducteur selon l'une des revendications 1 et 2, **caractérisé par le fait que** lesdits moyens de connexion du substrat comprennent des plots ou billes de connexion extérieure (8) répartis sous la forme d'une matrice sur sa surface opposée à la pastille (2).

4. Dispositif semi-conducteur selon l'une quelconque des revendications précédentes, **caractérisé par le fait que** le substrat (6) constitue une portion de la paroi d'un boîtier (3) d'encapsulation de ladite pastille.

## Claims

1. Semiconductor device (1) comprising a die (2) forming an integrated circuit and a connection substrate (6), in which are provided, between the adjacent faces of the die (2) and of the substrate (6), connection point-like elements or beads (10) arranged in the form of a matrix and in which the substrate (6) has external connection means (8) connected to the said point-like connection elements (10), also comprising at least one light signal exchange means disposed within a region clear of point-like connection elements and comprising two opto-electronic parts respectively comprising at least one emitter and at least one receiver disposed remotely from and facing one another and capable of exchanging light signals between one another, one (17) of the said parts being integrated into the said die (2) and forming a component of the said integrated circuit and the other part (18) comprising at least one optical fibre (22), one end part (23) of which is mounted through an orifice (24) passing through the said substrate (6) in such a manner as to couple optically and remotely the end of the said fibre (22) to the part of the said exchange means integrated into the said die (2) across the gap (11) separating the die (2) and the substrate (6), **characterized in that** the sidewall (6) of the orifice (24) passing through the said substrate (6) and receiving the end (23) of the said fibre (22) has axial grooves (24a) and **in that** it comprises a resin for sealing, gluing and mechanically reinforcing (11a), and transparent to the said light signals, injected into the gap (11) separating the said die (2) and the said substrate (6) and fixing the said optical fibre in the said orifice (24) by penetrating into the said axial grooves (24a).

2. Semiconductor device according to Claim 1, **characterized in that** the said orifice (24) runs perpendicularly to the gap (11) separating the die and the substrate.

3. Semiconductor device according to either of Claims 1 and 2, **characterized in that** the said connection means of the substrate comprise external connection pads or beads (8) arranged in the form of a matrix on the opposite surface to the die (2).

4. Semiconductor device according to any one of the preceding claims, **characterized in that** the substrate (6) forms one portion of the outer wall of a package (3) for encapsulating the said die.

## Patentansprüche

1. Halbleitervorrichtung (1) mit einer Pille (2) die einen integrierten Schaltkreis bildet, und mit einem Anschlusssubstrat (6) in welchem, zwischen den nebeneinanderliegenden Seiten der Pille (2) und des Substrats (6), in Matrixform verteilte punktförmige Anschlusselemente oder Anschlusskugeln (10) vorgesehen sind, und in welchem das Substrat (6) äußere Anschlussmittel (8) aufweist, die mit den erwähnten punktförmigen Anschlusselementen (10) verbunden sind, mit außerdem mindestens einem Mittel zum Austausch von Leuchtsignalen, das in einem Bereich ohne punktförmige Anschlusselemente angeordnet ist und zwei optoelektronische Teile umfasst, die jeweils mindestens einen Sender und mindestens einen Empfänger umfassen, die voneinander beabstandet und gegenüberliegend angeordnet sind, und die in der Lage sind, untereinander Leuchtsignale auszutauschen, wobei einer der erwähnten Teile (17) in der erwähnten Pille (2) integriert ist und eine Komponente des erwähnten integrierten Schaltkreises darstellt, und der andere Teil (18) mindestens eine Lichtleitfaser (22) umfasst, deren eines Endteil (23) durch eine Durchgangsöffnung (24) des erwähnten Substrats (6) hindurch eingeführt ist, um das Ende der erwähnten Faser (22) mit Abstand mit dem in der erwähnten Pille (2) integrierten Teil des erwähnten Austauschmittels durch den Raum (11) hindurch, der die Pille (2) und das Substrat (6) trennt, optisch zu koppeln, **dadurch gekennzeichnet, dass** die Wandung (6) der Öffnung (24) die das erwähnte Substrat (6) durchdringt und das Ende (23) der erwähnten Faser (22) aufnimmt Axialnuten (24a) aufweist, sowie ein Dichtungs-, Klebe- und mechanisches Verstärkungsharz (11a) umfasst, das gegenüber den erwähnten Leuchtsignalen durchlässig ist, das in den Raum (11) eingespritzt wird, der die erwähnte Pille (2) und das erwähnte Substrat (6) trennt, und das die erwähnte Lichtleitfaser in der erwähnten Öffnung (24) befestigt, indem es in die erwähnten Axialnuten (24a) eindringt.

2. Halbleitervorrichtung nach Anspruch 1, **dadurch gekennzeichnet, dass** die erwähnte Öffnung (24) sich senkrecht zum Raum (11) erstreckt, der die Pille und das Substrat trennt.

3. Halbleitervorrichtung nach einem der Ansprüche 1 und 2, **dadurch gekennzeichnet, dass** die erwähnten Anschlussmittel des Substrats äußere Anschlusskontaktstücke oder Kontaktkugeln (8) umfassen, die auf dessen der Pille (2) gegenüberliegenden Fläche in Matrixform verteilt sind.

4. Halbleitervorrichtung nach einem der vorhergehenden Ansprüche, **dadurch gekennzeichnet, dass** das Substrat (6) einen Teil der Wandung eines Kapselgehäuses (3) der erwähnten Pille bildet.
